(19) Europäisches Patentamt / European Patent Office / Office européen des brevets

(11) **EP 3 032 923 B1**

(12) **EUROPEAN PATENT SPECIFICATION**

(45) Date of publication and mention of the grant of the patent:
**04.12.2019 Bulletin 2019/49**

(51) Int Cl.:
*H05B 33/20* (2006.01)          *H01L 33/50* (2010.01)
*B32B 27/38* (2006.01)          *F21K 9/64* (2016.01)
*F21Y 115/10* (2016.01)          *C09K 11/02* (2006.01)

(21) Application number: **15001199.7**

(22) Date of filing: **22.04.2015**

(54) **METHOD FOR PREPARING LIGHT CONVERSION COMPOSITE, LIGHT CONVERSION FILM, BACKLIGHT UNIT AND DISPLAY DEVICE HAVING THE SAME**

VERFAHREN ZUR HERSTELLUNG EINER LICHTUMWANDLUNGSZUSAMMENSETZUNG, LICHTUMWANDLUNGSFILM, RÜCKBELEUCHTUNGSEINHEIT UND ANZEIGEVORRICHTUNG DAMIT

PROCÉDÉ DE PRÉPARATION DE COMPOSITE DE CONVERSION DE LUMIÈRE, FILM DE CONVERSION DE LUMIÈRE, UNITÉ DE RÉTROÉCLAIRAGE ET DISPOSITIF D'AFFICHAGE COMPRENANT CELLE-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **08.12.2014 KR 20140175301**

(43) Date of publication of application:
**15.06.2016 Bulletin 2016/24**

(73) Proprietor: **LG Electronics Inc.**
**Yeongdeungpo-gu**
**Seoul 150-721 (KR)**

(72) Inventors:
• **Sung, Jinwoo**
**137-893 Seoul (KR)**
• **OH, Jinmok**
**137-893 Seoul (KR)**
• **Jang, Dongseon**
**137-893 Seoul (KR)**

(74) Representative: **Katérle, Axel**
**Wuesthoff & Wuesthoff**
**Patentanwälte PartG mbB**
**Schweigerstraße 2**
**81541 München (DE)**

(56) References cited:
**EP-A1- 2 660 885          WO-A2-2005/001889**
**US-A1- 2010 123 155          US-A1- 2010 155 744**
**US-A1- 2011 227 034          US-A1- 2013 075 692**

**Description**

BACKGROUND OF THE INVENTION

**Field of the Invention**

The present disclosure relates to a light conversion composite and a method for preparing the same, and more particularly, to a light conversion composite that is used for preparing a light conversion film having superior luminescence efficiency and low degradation at an edge portion under high-temperature high-humidity environments.

**Discussion of the Related Art**

Liquid crystal displays (LCDs), plasma display panel devices (PDPs), electroluminescence displays (ELDs), field emission displays (FEDs), and the like have been introduced as flat panel displays (FPDs) having advantages such as slimness, lightweight, low power consumption, and the like as a substitute for existing cathode ray tubes (CRTs).
Among these, LCDs have been in the spotlight as next-generation high-tech display devices because of low power consumption, good portability, technology compactness, and high added-value. In more detail, LCDs are non-emissive type devices and thus do not form an image by itself. Thus, LCDs require an additional light source to form an image. Cathode fluorescent lamps (CCFLs) have been mainly used as light sources in the past. However, CCFLs have a difficulty in securing brightness uniformity and are deteriorated in color purity when the CCFLs are manufactured in large scale.
Thus, three-color light emitting diodes (LEDs) instead of the CCFLs are being used as light sources of LCDs. When three-color LEDs are used, a high color purity can be realized thereby implementing high-quality images. However, because the three-color LEDs are very expensive, the manufacturing costs increase. As a result, relatively inexpensive blue LEDs are being used as light sources. In this instance, a light conversion film is used for converting blue light into red light and green light. The light conversion film also includes quantum dots (QDs).
It is preferable to uniformly disperse the QDs into a matrix resin. However, if the QDs are aggregated, light emitted from a light source passes through at least two QDs and thus is reabsorbed to deteriorate the light emitting efficiency. In addition, the QDs generally have surfaces that are capped using hydrophobic ligands so as to improve dispersibility. The types of dispersible media is extremely limited, however, and thus the types of resins used for manufacturing films is also limited.
In addition, related art light conversion films that include a barrier film attached on top and bottom surfaces of the light conversion film. However, the QDs located in an edge portion of the film are oxidized by oxygen or moisture permeated through a side surface to which a separate barrier unit is not attached.
Thus, a matrix resin having a low penetration ratio with respect to oxygen or moisture may be used. However, the QDs are not well dispersed into resins having a low vapor-permeation rate and/or moisture-permeation rate. Therefore, matrix resins having a low vapor-permeation rate and/or moisture-permeation rate are heated at a high temperature and then mixed with QDs. However, because the QDs are easily degraded at a high temperature, the QDs are deteriorated in light emitting efficiency.
EP 2 660 885 A1 discloses an optical device comprising a substrate, a first transparent thin film layer formed at a surface of the substrate, a quantum dot layer formed at an upper surface of the first transparent thin film layer and consisting of quantum dot particles, a protective layer formed on at least one of an upper surface or a bottom surface of the quantum dot layer and formed with metallic oxide nano particles; and a barrier member formed on the upper surface of the first transparent thin film layer for establishing an area formed with the quantum dot layer and the protective layer.
US 2011/227034 A1 discloses quantum dot-block copolymer hybrids dispersed into a matrix resin.

SUMMARY OF THE INVENTION

Accordingly, one aspect of the present invention is to provide a light conversion composite in which quantum dots are uniformly dispersed within various matrix resins, particularly, a matrix resin having low moisture-permeability and vapor-permeability and a method for preparing the same.
In another aspect, the present invention provides a light conversion film having superior light emitting efficiency by using a light conversion composite and improved quantum-dot degradation properties at an edge portion, a backlight unit and display device including the same.
To achieve these and other advantages and in accordance with the purpose of the present invention, as embodied and broadly described herein, the present disclosure provides in one aspect a light conversion composite including a matrix resin; and quantum dot-polymer beads dispersed within the matrix resin. Further, the light conversion composite has a wave number q of 0.0056 Å$^{-1}$ to 0.045 Å$^{-1}$ at a peak point in a scattering intensity graph according to wave numbers measured by using small angle X-ray scattering. The present invention provides a corresponding light conversion film, backlight unit and display device using the light conversion composite and the present disclosure provides corresponding methods of manufacturing the same.

Further scope of applicability of the present invention will become apparent from the detailed description given hereinafter. However, it should be understood that the detailed description and specific examples, while indicating preferred embodiments of the invention, are given by illustration only, since various changes and modifications within the scope of the invention will become apparent to those skilled in the art from this detailed description.

## BRIEF DESCRIPTION OF THE DRAWINGS

The present invention will become more fully understood from the detailed description given hereinbelow and the accompanying drawings, which are given by illustration only, and thus are not limitative of the present invention, and wherein:

Fig. 1 is a view illustrating a method for preparing a light conversion composite according to an embodiment.
Fig. 2 is a view of a light conversion composite according to an embodiment.
Fig. 3 is a view illustrating a quantum dot-polymer bead according to an embodiment.
Fig. 4 is a cross-sectional view of a light conversion film according to an embodiment.
Fig. 5 is an exploded perspective view of a display device according to an embodiment.
Fig. 6 is a cross-sectional view taken along line I-I' of Fig. 5.
Fig. 7 is an optical microscope photograph of a quantum dot-polymer bead prepared according to Preparation Example 1.
Fig. 8 is a confocal microscope photograph of a light conversion film prepared according to Embodiment 1.
Fig. 9 is a confocal microscope photograph of a light conversion film prepared according to a comparative example.
Figs. 10 and 11 are graphs of scattering intensities depending on wave numbers of a light conversion films according to Embodiments 1 to 4, which are measured by a small angle X-ray scattering method.
Fig. 12 is a graph showing light emitting efficiency in a light conversion film according to Embodiment 1 and a light conversion film according to a comparative example.
Fig. 13 is a photograph showing a degree of edge degradation in the light conversion film according to Embodiment 1 and the light conversion film according to a comparative example.

## DETAILED DESCRIPTION OF THE EMBODIMENTS

Advantages and features of the present disclosure, and implementation methods thereof will be clarified through following embodiments described with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present disclosure to those skilled in the art.

Because a shape, a ratio, an angle, a number, etc., which are shown in the accompanying drawings are exemplarily illustrated, the present disclosure is not limited thereto. Like reference numerals refer to like elements throughout. When 'comprising', 'having', 'consisting of', etc. are used, other components can be added unless 'only' is used. Even when a component is explained in singular number they may be interpreted as plural number.

When positional relation of two portions is explained by 'on', 'upper', 'lower', 'beside', etc., one or more components may be positioned between two portions unless 'just' is not used. Even though terms such as 'after', 'before', 'next to', 'and', 'herein', 'subsequent to', 'at this time', etc. are used, they are not used as limiting temporal position.

Although the terms of first and second are used herein to describe various elements, these elements should not be limited by these terms. These terms are only used to distinguish one component from another component. Accordingly, a first component that will be described below may be a second component within the technical idea of the present disclosure.

Features of various embodiments of the present disclosure are partially or entirely coupled or combined with each other, and technically various interlocking and driving are enabled. Also, the embodiments may be independently performed with respect to each other, or performed in combination of each other.

The inventors conducted experiments so as to develop a light conversion material that can uniformly disperse quantum dots within a matrix resin having low moisture-permeability and/or vapor-permeability and is capable of minimizing quantum dot degradation. The inventors determined the above-described objective is achieved by using a novel quantum dot-polymer bead prepared using a solvent volatilization method.

A method for preparing a light conversion composite according to an embodiment includes preparing a quantum dot-polymer bead; mixing the quantum dot-polymer bead with a matrix resin to form a mixed solution; and curing the mixed solution. Here, the quantum dot-polymer bead is prepared by using the solvent volatilization method. According to the current embodiment, when the quantum dot-polymer bead is performed by using the solvent volatilization method, since the quantum dot-polymer bead is prepared without performing a high-temperature process, the quantum dot degradation that occurs in the high-temperature process can be prevented.

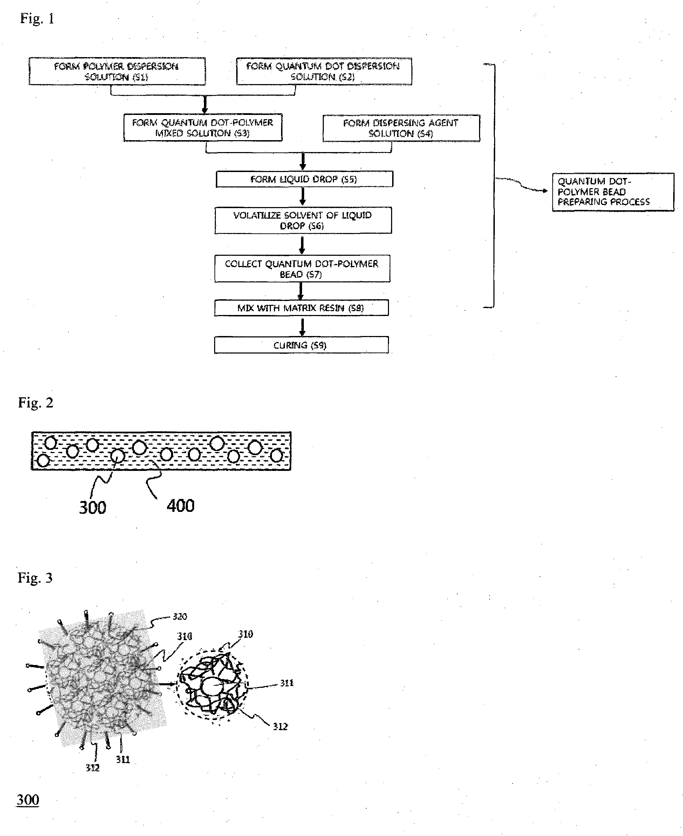

Next, Fig. 1 is a view illustrating a method for preparing a light conversion composite according to an embodiment. Hereinafter, each process will be described in more detail with reference to Fig. 1. First, in operation S1, a polymer and a first solvent are mixed with each other to form a polymer dispersion solution.

Here, the polymer may be a polymer having affinity with respect to surfaces of quantum dots. For example, the polymer may be a polymer having a solubility parameter of about 19 $Pa^{1/2}$ to about 24 $MPa^{1/2}$. According to the studies and experiments conducted by the inventors, when a polymer having a solubility parameter within the above-described ranges is used, the surface of the quantum dot and a polymer chain are smoothly bonded to form a polymer coating layer on the surface of the quantum dot. The solubility parameter used in the current embodiment may be calculated by using group contribution methods described in Chapter 7 of Polymer handbook (editors, J. Brandrup, E. H. Immergut, E. A. Grulke; associate editors, A. Abe, D. R. Bloch. 4th ed. New York: John Wiley & Sons c1999). Here, values written on Table 2 of Chapter 7 of the cited document may be used as absolute values of each of the groups that are used for calculating.

More particularly, the polymer may have a polar group on a main chain or side chain. For the polymer having the polar group, the polar group may be adsorbed on the surface of the quantum dot to easily form the polymer coating layer. For example, the polymer may be a homopolymer or copolymer, which includes at least one kind of material selected from the group consisting of polyester, ethyl cellulose, polyvinylpyridine, and a combination thereof, on the main chain. Among these, the polyester may be preferably selected because the polyester has a less degradation effect with respect to the quantum dot.

Also, the polymer may have a polar group on the side chain. Here, the polar group may include an oxygen component. For example, the polar group may be one selected from the group consisting of -OH, -COOH, -COH, -CO, -O-, and a combination thereof. Also, the polymer may be a partially oxidized polymer. The partially oxidized polymer may represent a polymer in which an oxygen component is irregularly introduced on the main chain or side chain. For example, the partially oxidized polymer may be partially oxidized polyester.

Also, the polymer may have a number-average molecular weight of about 300 g/mol to about 100,000 g/mol. If the polymer has a number-average molecular weight less than that of about 300 g/mol, the quantum dots within the quantum dot-polymer bead may not be sufficiently spaced apart from each other to deteriorate the light emitting efficiency. Further, if the polymer has a number-average molecular weight greater than that of about 100.000 g/mol, the bead may significantly increase in size to cause defects in a filming process.

The first solvent may be used for dissolving the polymer. Preferably, the first solvent may be a nonpolar solvent. In a solvent volatilization process that will be described later, the first solvent may be a high volatile solvent having a low boiling point. For example, the first solvent may be a solvent having a boiling point of about 85°C or less, preferably, about 50°C to about 80°C, more preferably, about 60°C to about 70°C. More particularly, the first solvent may be tetrahydrofuran (boiling point of about 66°C), chloroform (boiling point of about 61°C), cyclohexane (boiling point of about 81°C), hexane (boiling point of about 68.5°C to about 69.1 °C), or ethyl acetate (boiling point of about 77.15°C). Among these, chloroform may be preferable.

A polymer within the polymer dispersion solution may have a content of about 15 wt% to about 35 wt% of the polymer dispersion solution. When the polymer content is less than about 15 wt%, a solvent volatile amount may increase to form a significantly large number of pores within the quantum dot-bead. Further, when the polymer content is greater than about 35 wt%, the viscosity may increase to deteriorate film deformability. In consideration of the film deformability, the polymer dispersion solution may have a viscosity of about 500 cP to about 1,000 cP.

Next, in operation S2, the quantum dots and a second solvent are mixed with each other to form a quantum dot dispersion solution. Here, a time point for forming the quantum dot dispersion solution is not specifically limited. For example, a process of forming the quantum dot dispersion solution and forming the polymer dispersion solution may be performed at the same time. Alternatively, the process of forming the quantum dot dispersion solution may be performed before or after the process of forming the polymer dispersion solution.

In addition, the quantum dot is a light emitting nano-particle, i.e., a several nano-sized semiconductor crystal having a quantum confinement effect. The semiconductor crystal converts a wavelength of light incident from a light source to emit light having the converted wavelength. The quantum dot may be, for example, a particle having a single layer or multi-layered structure including at least one kind of semiconductor crystal selected from the group consisting of CdS, CdO, CdSe, CdTe, $Cd_3P_2$, $Cd_3As_2$, ZnS, ZnO, ZnSe, ZnTe, MnS, MnO, MnSe, MnTe, MgO, MgS, MgSe, MgTe, CaO, CaS, CaSe, CaTe, SrO, SrS, SrSe, SrTe, BaO, BaS, BaSe, BaTE, HgO, HgS, HgSe, HgTe, $HgI_2$, AgI, AgBr, $Al_2O_3$, $Al_2S_3$, $Al_2Se_3$, $Al_2Te_3$, $Ga_2O_3$, $Ga_2S_3$, $Ga_2Se_3$, $Ga_2Te_3$, $In_2O_3$, $In_2S_3$, $In_2Se_3$, $In_2Te_3$, $SiO_2$, $GeO_2$, $SnO_2$, SnS, SnSe, SnTe, PbO, $PbO_2$, PbS, PbSe, PbTe, AlN, AlP, AlAs, AlSb, GaN, GaP, GaAs, GaSb, $GaInP_2$, InN, InP, InAs, InSb,

$In_2S_3$, $In_2Se_3$, $TiO_2$, BP, Si, Ge, and a combination thereof.

The quantum dot may have a diameter of about 1 nm to about 10 nm. Because the quantum dot varies in light emitting wavelength according to its size, a quantum dot having an adequate size may be selected to obtain light having a desired color. In the current embodiment, the quantum dot may include, for example, at least one kind of quantum dot selected from the group consisting of a red light emitting quantum dot that converts incident light into red light and a green light emitting quantum dot that converts incident light into green light.

The quantum dot may also include a capping layer on the surface thereof to prevent the quantum dots from being aggregated with respect to each other. The capping layer may be a ligand layer that is coordinate bonded to the surface of the quantum dot or a surface layer coated with a hydrophobic organic molecule.

For example, the capping layer may be a material layer selected from the group consisting of phosphine oxide, organic amine, organic acid, phosphonic acid, which have a long chain alkyl or aryl group, and a combination thereof. For example, the capping layer may be a material layer selected from the group consisting of tri-n-octylphosphine oxide (TOPO), stearic acid, palmitic acid, octadecylamine, dodecylamine, lauric acid, oleic acid, hexyl phosphonic acid, and a combination thereof.

The second solvent may dissolve the quantum dot to improve miscibility with the polymer dispersion solution or substitute for a solvent of a quantum dot solution that comes into the market. Preferably, the second solvent is a nonpolar solvent. In general, the quantum dot comes in a solution state such as when toluene is dissolved. In the current embodiment, the solvent of the quantum dot solution can substitute for the second solvent to improve the miscibility with the polymer dispersion solution.

For this, the second solvent may be a solvent having miscibility with the first solvent. Also, to perform the solvent volatilization process that will be described later at room temperature, the second solvent may be a high volatile solvent having a low boiling point. For example, the first solvent may be a solvent having a boiling point of about 85°C or less, preferably, about 50°C to about 80°C, more preferably, about 60°C to about 70°C. More particularly, the second solvent may be tetrahydrofuran (boiling point of about 66°C), chloroform (boiling point of about 61°C), cyclohexane (boiling point of about 81°C), hexane (boiling point of about 68.5°C to about 69.1°C), or ethyl acetate (boiling point of about 77.15°C). Among these, chloroform may be preferable.

The first solvent and the second solvent may be the same or different from each other. In consideration of process convenience and miscibility, it may be preferable that the first and second solvents are the same. When the polymer dispersion solution and the quantum dot dispersion solution are formed through the above-described processes, the two solutions are mixed with each other to form a quantum dot-polymer mixed solution in operation S3.

Because the polymer having affinity with the quantum dot surface is used in the current embodiment, when the polymer dispersion solution and the quantum dot dispersion solution are mixed with each other, a portion of a polymer chain may be bonded to the quantum dot surface to form a brush layer. That is, the polymers may surround the quantum dot surface to form a polymer coating layer. Thus, the quantum dots may not be aggregated with each other by the polymer coating layer and spaced apart from each other. As a result, the deterioration in light emitting efficiency due to the aggregation of the quantum dots can be minimized.

Next, in operation S4, a dispersing agent and a third solvent are mixed with each other to form a dispersing solution. Here, a time point for forming the dispersing solution is not specifically limited. For example, a process of forming the dispersing solution and the process of forming the quantum dot-polymer mixed solution may be performed at the same time. Alternatively, the process of forming the dispersing solution may be performed before or after the process of forming the quantum dot-polymer mixed solution.

The dispersing solution may form a liquid drop including a quantum dot and polymer through phase separation in the following process. A polar solvent that is phase-separable from the first and second solvents may be used as the third solvent. For example, water may be used as the third solvent.

The dispersing agent helps maintain the phase separation between the liquid drop and the third solvent and may be an amphiphilic unimolecular or polymer. Also, the dispersing agent may be an ionic dispersing agent or nonionic dispersing agent. For example, the dispersing agent may be polyvinyl alcohol.

A content of the dispersing agent within the dispersing solution may range from about 0.1 wt% to about 5 wt%, preferably range from 0.5 wt% to about 1 wt%. When the content of the dispersing agent is less than about 0.1 wt%, it may be difficult to form and maintain the liquid drop. Further, when the content of the dispersing agent is greater than about 5 wt%, the liquid drop may decrease in size, and the light emitting efficiency may be deteriorated.

Next, in operation S5, the quantum dot-polymer dispersion solution and the dispersing solution are mixed with each other to form a liquid drop including a quantum dot and polymer. As described above, because the quantum dot-polymer mixed solution includes a nonpolar solvent, and the dispersing solution includes a polar solvent, the quantum dot-polymer mixed solution and the dispersing solution may be phase-separated from each other without being mixed with each other to form a liquid drop. Here, the quantum dot, the polymer, and the solvent (i.e., the nonpolar solvent) of the quantum dot-polymer mixed solution may exist in the liquid drop, and the polar solvent that is a solvent of the dispersing solution may exist outside the liquid drop. To smoothly form the liquid drop, the mixing of the quantum dot-polymer mixed solution and the dispersing solution may be performed by using a homogenizer.

The dispersing agent may be bonded to a surface of the liquid drop to prevent the liquid drops from being aggregated, thereby maintaining the shape of the liquid drip. More particularly, the dispersing agent may have one side disposed on the surface of the liquid drop that is the nonpolar solvent and the other side disposed on the polar solvent to allow the dispersing agents to surround the liquid drop, thereby maintaining the shape of the liquid drop. The liquid drop may be adjusted in size according to a concentration of the dispersing agent. For example, the more the dispersing agent increases in concentration, the more the liquid drop decreases in size.

When the liquid drop is formed through the above-described processes, the solvent existing in the liquid drop is volatilized in operation S6. The process of volatilizing the solvent existing in the liquid drop may be performed by a method in which the solution having the liquid drop is decompressed at room temperature. More particularly, nitrogen is purged at one side of the solution, and simultaneously, a vacuum is generated at the other side by using a pump to volatilize the solution of the liquid drop. Because the solvent of the quantum dot-polymer mixed solution existing in the liquid drop is the high-volatile nonpolar solvent having a low boiling point, the solvent may be easily volatilized by being only decompressed without performing a separate heating process.

To prevent the liquid drops from being re-aggregated during the volatilization of the solvent, the solvent may be stirred by using a magnetic stirrer. For example, the solvent may be stirred at a rate of about 100 rpm. A time taken for volatilizing the solvent may be adequately adjusted according to kinds of solvent existing in the liquid drop. For example, when chloroform is used as the first and second solvents, a time taken for volatilizing the solvent may be about 1 hour.

When the solvent within the liquid drop is volatilized through the above-described process, a quantum dot-polymer bead including the quantum dot and polymer may be formed. When the bead is formed through the solvent volatilization method as described in the current embodiment, a pore may be formed in an empty space, which is formed after the solvent is volatilized, within the quantum dot-polymer bead.

Next, in operation S7, the quantum dot-polymer bead is collected. The collection of the quantum dot-bead may be performed by collecting, cleaning, and drying the quantum dot-bead. First, a filtering process is performed by using a filtering device to collect a quantum dot-polymer bead on a filter. Then, the quantum dot-polymer bead on the filter may be cleaned several times by using methanol and water.

When the quantum dot-polymer bead is dried after being collected, the quantum dot-polymer bead may become a hard powder. Thus, it may be difficult to re-disperse the quantum dot-polymer bead. However, if the collected quantum dot-polymer bead is cleaned by using the methanol, when the quantum dot-polymer bead is dispersed into the solvent after being dried, the quantum dot-polymer bead may be well dispersed.

Then, to remove the remaining moisture and methanol, the quantum dot-polymer can be obtained by being dried within a vacuum chamber. The processes (S1 to S8) of preparing the quantum dot-polymer bead may be performed at room temperature without performing a heating or cooling process. Thus, the degradation of the quantum dot, which occurs by a variation in temperature can be minimized. The quantum dot-polymer bead prepared through the above-described process may have a mean particle diameter of about 5 $\mu$m to about 200 $\mu$m. Also, quantum dots 301 within the quantum dot-polymer bead may have a concentration of about 0.1 wt% to about 1 wt%.

When the quantum dot-polymer bead is obtained through the above-described method, the obtained quantum dot-polymer bead may be mixed with a matrix resin to prepare a mixed solution of the quantum dot-polymer bead and the matrix resin in operation S8. Here, the matrix resin may have a resin having low vapor-permeability and moisture-permeability. For example, the matrix resin may include epoxy, epoxy acrylate, polychloro tri-fluoroethylene, polyethylene, polypropylene, polyvinyl alcohol, and a combination thereof.

The epoxy resin may be a resin having an epoxy group, for example, a bisphenol A resin, a bisphenol F resin, and the like. The epoxy resins may have a low moisture-permeation rate and vapor-permeation rate due to characteristics of a main chain.

The epoxy acrylate resin may be a resin in which an epoxide group of an epoxy resin substitutes for an acrylic group. For example, the epoxy acrylate resin may be one selected from the group consisting of bisphenol A glycerolate diacrylate, bisphenol A ethoxylate diacrylate, bisphenol A glycerolate dimethacrylate, bisphenol A ethoxylate dimethacrylate, and a combination thereof. The epoxy acrylate resin may have a low moisture-permeation rate and vapor-permeation rate due to characteristics of a main chain, like the epoxy resin.

Also, the polychloro tri-fluoroethylene may have low moisture and oxygen permeability, the polyethylene and polypropylene may have low moisture permeability, and the polyvinyl alcohol may have low oxygen permeability. Further, the matrix resin may be provided in a liquidity solution state in which a resin is dissolved into a solvent in consideration of compatibility with the quantum dot-polymer bead. When a light conversion layer is formed, a photo-initiator for photo-curing may be further provided.

In operation S9, the mixed solution of the quantum dot-polymer bead and the matrix resin may be cured to obtain a light conversion composite. Here, the curing may be performed through the photo-curing. For example, the mixed solution may be applied to a base material, and then, active energy rays such as ultraviolet rays may be irradiated to perform the photo-curing.

Next, the light conversion composite according to an embodiment, which is prepared through the above-described method will be described below. In particular, Fig. 2 is a view of the light conversion composite according to an embodiment. As illustrated in Fig. 2, the light conversion composite according to an embodiment includes a matrix resin 400 and a quantum dot-polymer bead 300 dispersed within the matrix resin 400. Here, the light conversion composite may have a wave number q of 0.0056 $Å^{-1}$ to 0.045 $Å^{-1}$, preferably, 0.01 $Å^{-1}$ to 0.040 $Å^{-1}$, and more preferably, 0.020 $Å^{-1}$ to 0.030 $Å^{-1}$ at a peak point of an intensity graph according to wave numbers measured by small angle X-ray scattering.

In addition, the small angle X-ray scattering is used for measuring a nano structure having several nano meter scales to several ten nano meter scales by using X-ray diffraction information in a range of a very small scattering angle, for example, within a scattering angle of about 3°. More particularly, the measuring of a material structure using the small angle X-ray scattering may be, for example, performed using a method in which a transmission small angle X-ray scattering beam of the Pohang light source (PLS) is projected onto a target material to be measured to obtain a scattering intensity graph according to wave numbers, and then calculate a distance between materials or a distribution of the materials.

In order to look into a structure of the light conversion composite according to an embodiment, the light conversion composite prepared according to the above-described method was cured, and then, the transmission small angle X-ray scattering beam of the PLS was transmitted through the cured light conversion composite. As a result, it was confirmed that the light conversion composite has a wave number q of 0.0056 $Å^{-1}$ to 0.045 $Å^{-1}$ at the peak point of the intensity graph according to the wave numbers. The wave number q may be a value that relates to a surface distance between the quantum dots, and thus, a distance between the quantum dots may be calculated from the wave number q through the following Equation 1.

$$\text{Equation 1: } q = 4\pi \sin\theta/\lambda = 2\pi/d$$

In Equation 1, q is a wave number, $\theta$ is a scattering angle, $\lambda$ is an X-ray wavelength, and d is a surface distance.

When a quantum dot distance within the light conversion composite is calculated through Equation 1, the quantum dot distance is about 14 nm to about 112 nm. In general, when considering the quantum dot has a diameter of about 2 nm to about 8 nm, a ligand attached to a surface of the quantum dot has a length of about 1 nm to about 2 nm, and if the quantum dots are aggregated with each other, a distance between the quantum dots may be about 4 nm to about 12 nm. That is, when a wave number q at a peak point on the scattering intensity graph with respect to the wave number measured by the small angle X-ray scattering is 0.0056 $Å^{-1}$ to 0.045 $Å^{-1}$, the quantum dots within the light conversion composite are well dispersed without being aggregated.

As described above, the uniform dispersion of the quantum dots within the light conversion composite is determined because the quantum dot-polymer bead used in the current embodiment is not composed of only the quantum dots and polymers, but is provided as quantum dot-polymer units, and thus, the plurality of monomers are aggregated to form the quantum dot-polymer bead having the form of a cluster.

Next, Fig. 3 is a view illustrating the quantum dot-polymer bead according to an embodiment. Referring to Fig. 3, the quantum dot-polymer bead 300 according to an embodiment may be formed by aggregating the plurality of quantum dot-polymer units 310. Thus, each of the quantum dot-polymer units may include a quantum dot 311 and a polymer 312 of which a portion of a chain is bonded to a surface of the quantum dot to form a coating layer.

Here, specific characteristics and components of the quantum dot 311 and the polymer 312 are the same as described above. That is, quantum dot 311 may include, for example, at least one kind of material selected from the group consisting of a red light emitting quantum dot that converts incident light into red light and a green light emitting quantum dot that converts incident light into green light. More particularly, the quantum dot 311 may include, for example, a particle having a single layer or multi-layered structure including at least one kind of semiconductor crystal selected from the group consisting of $CdS$, $CdO$, $CdSe$, $CdTe$, $Cd_3P_2$, $Cd_3As_2$, $ZnS$, $ZnO$, $ZnSe$, $ZnTe$, $MnS$, $MnO$, $MnSe$, $MnTe$, $MgO$, $MgS$, $MgSe$, $MgTe$, $CaO$, $CaS$, $CaSe$, $CaTe$, $SrO$, $SrS$, $SrSe$, $SrTe$, $BaO$, $BaS$, $BaSe$, $BaTE$, $HgO$, $HgS$, $HgSe$, $HgTe$, $HgI_2$, $AgI$, $AgBr$, $Al_2O_3$, $Al_2S_3$, $Al_2Se_3$, $Al_2Te_3$, $Ga_2O_3$, $Ga_2S_3$, $Ga_2Se_3$, $Ga_2Te_3$, $In_2O_3$, $In_2S_3$, $In_2Se_3$, $In_2Te_3$, $SiO_2$, $GeO_2$, $SnO_2$, $SnS$, $SnSe$, $SnTe$, $PbO$, $PbO_2$, $PbS$, $PbSe$, $PbTe$, $AIN$, $AIP$, $AIAs$, $AISb$, $GaN$, $GaP$, $GaAs$, $GaSb$, $GaInP_2$, $InN$, $InP$, $InAs$, $InSb$, $In_2S_3$, $In_2Se_3$, $TiO_2$, $BP$, $Si$, $Ge$, and a combination thereof.

Also, the polymer 312 may be a polymer having a solubility parameter of about 19 $Mpa^{1/2}$ to about 24 $MPa^{1/2}$, preferably, a polymer having a polar group on a main chain or side chain. For example, the polymer may be a homopolymer or copolymer, which includes at least one kind of material selected from the group of polyester, ethyl cellulose, polyvinylpyridine, and a combination thereof, on the main chain or a polymer, which has at least one kind of polar group selected from the group consisting of -OH, -COOH, -COH, -CO, -O-, and a combination thereof, on the side chain. Alternatively, the polymer may be a partially oxidized polymer such as partially oxidized polyester. Also, the polymer may have a number-average molecular weight of about 300 g/mol to about 100,000 g/mol.

Specific characteristics and components of the matrix resin 400 are the same as described above. That is, the matrix resin may have a resin having low moisture-permeability and vapor-permeability. For example, the matrix resin may include epoxy, epoxy acrylate, polychloro tri-fluoroethylene, polyethylene, polypropylene, polyvinyl alcohol, and a combination thereof.

The light conversion composite may further include a dispersing agent 320. The dispersing agent 320 may be a dispersing agent included in the dispersing solution that is described in the preparing method. The dispersing agent 320 may be attached to a surface of the quantum dot-polymer bead 300 to perform a supplementary function so that the quantum dot-polymer bead 300 is uniformly dispersed within the matrix resin 400. The dispersing agent 320 may be an amphiphilic unimolecular or polymer, preferably, may be polyvinyl alcohol. Also, the light conversion composite may further include a photo-initiator for photo-curing.

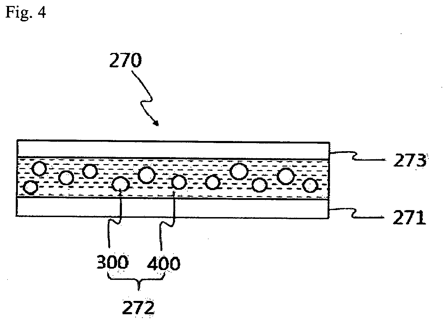

Next, a light conversion film according to an embodiment will be described below. Fig. 4 is a view of a light conversion film according to an embodiment. Referring to FIG. 4, a light conversion film 270 according to an embodiment includes a first barrier film 271, a light conversion layer 272, and a second barrier film 273. Here, the light conversion layer 272 converts a wavelength of light emitted from a light source and includes a light conversion composite.

In more detail, a mixed solution of a quantum dot-polymer bead and a matrix resin is applied between the first barrier film 271 and the second barrier film 273 to cure the applied mixed solution of the quantum dot-polymer bead and matrix resin, thereby preparing the light conversion film. In more detail, a method in which the second barrier film 273 is bonded and cured after the mixed solution of the quantum dot-polymer bead and the matrix resin is applied on the first barrier film 271 or a method in which the first barrier film 271 is bonded and cured after the mixed solution of the quantum dot-polymer bead and the matrix resin is applied on the second barrier film 273 may be performed. The curing may be performed through a photo-curing method. In addition, because the detailed descriptions with respect to the light conversion composite have been previously described, their detailed descriptions will be omitted.

Next, the first barrier film 271 and the second barrier film 273 support and protect the light conversion layer 272. In more detail, the first and second barrier films 271 and 273 help prevent moisture or oxygen in air from permeating into the light conversion layer 272, and degrading the quantum.

In more detail, the first and second barrier films 271 and 273 may include a single material or composite material having a high blocking property with respect to the moisture and/or oxygen. For example, the first and second barrier films 271 and 273 may include a polymer having a high blocking property with respect to the moisture and/or oxygen, for example, polyethylene, polypropylene, polyvinyl chloride, polyvinyl alcohol, ethylene vinylalcohol, polychlorotriplefluoroethylene, polyvinylidene chloride, nylon, polyamino ether, and cycloolefin-based homopolymer or copolymer.

In Fig. 4, each of the first and second barrier films 271 and 273 are provided as a single layer, but is not limited thereto. Each of the first and second barrier films 271 and 273 may be provided as a multilayer. For example, each of the first and second barrier films 271 and 273 may have a protection film stacked on a base material. For example, the first and second barrier films 271 and 273 may have an inorganic film or organic-inorganic hydride film having a high blocking property with respect to the moisture and/or oxygen applied to a base material.

Here, the inorganic film or organic-inorganic hydride film may be formed of oxide such as Si, Al, and the like or nitride as a main component. In this instance, a polymer film having high light transmittance and heat-resistance may be used as the base material. For example, a polymer film including polyethylene terephthalate (PET), polyethylene naphthalate (PEN), cyclic olefin copolymer (COC), cyclic olefin polymer (COC), and the like may be used as the base material.

Each of the first and second barrier films 271 and 273 may have a moisture-permeation rate of about $10^{-1}$ g/m$^2$/day to about $10^{-5}$ g/m$^2$/day under conditions of a temperature of about 37.8°C and relative humidity of about 100% and a moisture-permeation rate of about $10^{-1}$ cc/m$^2$/day/atm to $10^{-2}$ cc/m$^2$/day/atm under conditions of a temperature of about 23°C and relative humidity of about 0%. Also, each of the first and second barrier films 271 and 273 may have a linear permeation rate of about 88% to about 95% in a visible ray region of about 420 nm to about 680 nm.

As described above, the light conversion film 270 including the light conversion layer 272 formed of a light conversion composite according to an embodiment may have a wave number q of 0.0056 Å$^{-1}$ to 0.045 Å$^{-1}$, preferably, 0.01 Å$^{-1}$ to 0.040 Å$^{-1}$, more preferably, 0.020 Å$^{-1}$ to 0.030 Å$^{-1}$ at a peak point of an intensity graph according to wave numbers measured by small angle X-ray scattering. Thus, the quantum dots in the light conversion layer 272 may be uniformly dispersed. As a result, the light conversion film according to an embodiment can have superior light emitting efficiency due to low light reabsorption thereof.

Also, the light conversion film 270 according to an embodiment has significantly low degradation at an edge portion thereof under high-temperature high-humidity environments because of the light conversion layer 272 formed of the matrix resin having the low moisture-permeability and/or vapor-permeability. Particularly, the light conversion film according to an embodiment may have a damaged length of about 2 mm or less, preferably, about 1 mm or less after at the edge portion when a variation at the edge portion is measured after leaving the light conversion film for ten days under conditions of a temperature of about 60 °C and relative humidity of about 90%.

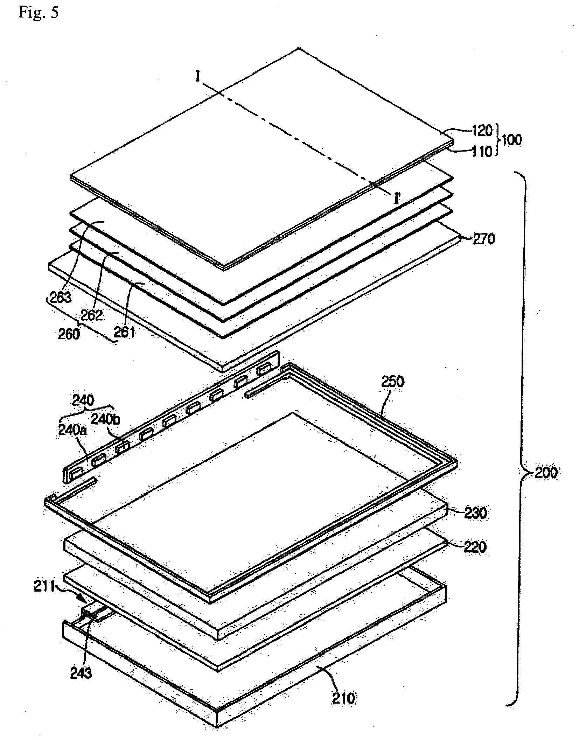

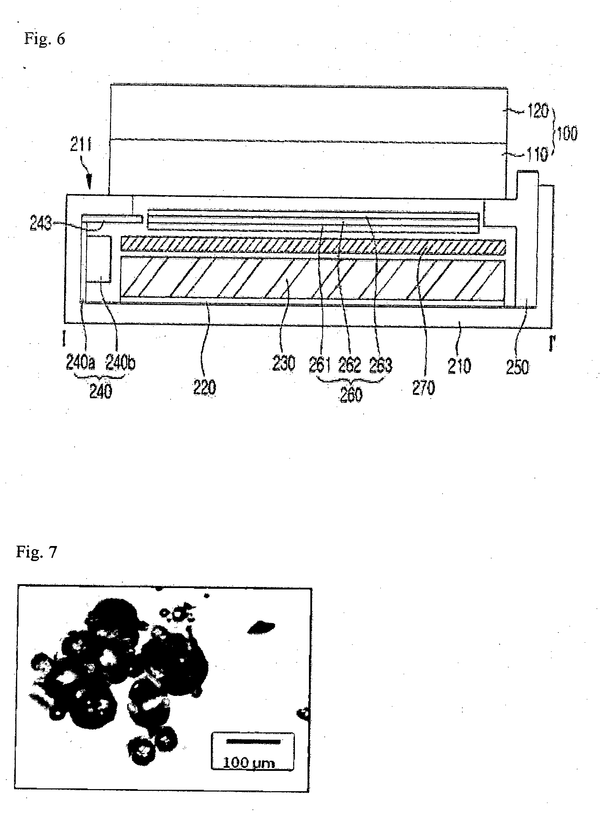

Next, a backlight unit and display device according to an embodiment will be described below. In particular, Fig. 5 is a view of a display device according to an embodiment, and Fig. 6 is a cross-sectional view taken along line I-I' of Fig. 5. As illustrated in Figs. 5 and 6, the display device according to an embodiment includes a backlight unit 200 and a display panel 100. Here, the backlight unit 200 provides light to the display panel 100. Thus, the backlight unit 200 includes a light source unit 240 including a plurality of light sources 240b and a light conversion film 270. Also, the backlight unit 200 may further include a bottom case 210, a reflection plate 220, a light guide plate 230, a guide panel 250, and an optical sheet 260. Because the detailed descriptions with respect to the light conversion film 270 are previously described, only other components of the backlight unit will be described.

First, the light source unit 240 provides light to the display panel 100 and is disposed within the bottom case 210. For example, the light source unit 240 includes a plurality of light sources 240b and a printed circuit board 240a on which the plurality of light sources 240b are mounted. Here, each of the light sources 240b may be a blue light source that emits blue light. For example, the light source 240b may be a blue light emitting diode. In this instance, the light conversion film 270 may include a red light emitting quantum dot that converts incident light into red light and a green light emitting quantum dot that converts incident light into green light.

Alternatively, the light source 240b may include a combination of the blue light source for emitting blue light and a green light source for emitting green light. For example, the light source 240b may be a combination of a blue light emitting diode and a green light emitting diode. Here, the light conversion film 270 may include a light conversion layer formed of a light conversion composite including red light emitting quantum dots that convert incident light into red light.

In this instance, because green light emitting quantum dots that have the majority of the quantum dots used in the light conversion film are not used, the demand quantity of quantum dots may be significantly reduced. As a result, the light conversion film can be reduced in manufacturing cost and thickness. Thus, the light conversion film is advantageous in slimness.

The printed circuit board 240a is electrically connected to the light source 240b. The light source 240b receives a driving signal through the printed circuit board 240a and thus is driven. The printed circuit board 240a can have a mount surface on which the light source 240b is mounted and an adhesion surface facing the mount surface. The adhesion surface of the printed circuit board 240a is attached to the bottom case 210. The printed circuit board 240a may have a bar shape and be disposed on one side of the bottom case 210.

Although the printed circuit board 240a is attached to an inner side surface of the bottom case 210 in the drawing, it is not limited thereto. The printed circuit board 240a may be attached to an inner top surface of the bottom case 210 or a lower surface of a bent extending part 211 of the bottom case 210.

Further, although the light source unit 240 is disposed on one side of the bottom case 210 in the drawing, it is not limited thereto. For example, the light source unit 240 may be disposed on each of both sides facing each other within the bottom case 210. Also, although an edge type backlight unit 200 is illustrated in the drawing, a direct type backlight unit 200 may be provided. That is, the light source unit 240 may be disposed on the inner top surface of the bottom case 210.

The bottom case 210 may have an opened upper portion. Also, the bottom case 210 may have a side wall that extends in a close-loop shape to accommodate the light emitting unit 240, the light guide plate 230, the reflection plate 220, the optical sheet 260, and the light conversion film 270. Here, at least one sidewall of the bottom case 210 may include a bent extending part 211 that is bent to extend from an upper edge, thereby covering the light source unit 240. That is, one side of the bottom case 210 may have a "⊏" -shaped cross-section. Here, a reflection member 243 may be further disposed on a bottom surface of the bent extending part 211.

The reflection member 243 may be a light source housing, a reflection film, or a reflection tape. The reflection member 243 prevents light emitted from the light source unit 240 from being directly emitted to the display panel 100. Also, the reflection member 243 increases an amount of light incident into the light guide plate 230. Thus, the reflection member 243 improves light efficiency, brightness, image quality of the display device.

In the bottom case 210, the bent extending part 211 may be omitted. That is, the bottom case 210 may have one side cross-section with "∟" shape. The bottom case 210 is coupled to the guide panel 250. Further, the guide panel includes a protrusion therein. The display panel may be seated on and supported by the protrusion of the guide panel 250. The guide panel 250 may be called a support main or mold frame.

The guide panel is disposed to surround an edge of the backlight unit 200 so as to be bonded to the display panel 100. That is, the guide panel 250 has a frame shape. For example, the guide panel 250 may have a rectangular frame shape. Also, the guide panel 250 may have an opening in an area of the bottom case 210 corresponding to the bent extending part 211.

In addition, each of the bottom case 210 and the guide panel 250 may have a hook shape or include a protrusion or recessed part so that they are assembled with and coupled to each other. Also, the bottom case 210 and the guide panel 250 may adhere to each other by using an adhesive. Further, the guide panel 250 may be disposed on the light source unit 240. Here, the reflection member 243 may be disposed on the bottom surface of the guide panel 250 corresponding to the light source unit 240.

Next, the light guide plate 230 uniformly guides light provided from the light source unit 240 to a liquid crystal display panel 100 through total reflection, refraction, and scattering. Here, the light guide plate 230 is accommodated into the bottom case 210. Although the light guide plate 230 has a predetermined thickness in the drawing, it is not limited to the shape of the light guide plate 230. For example, the light guide plate 230 may have a thickness that is slightly thinner than that of both sides or a central portion of the light guide plate 230 to reduce the total thickness of the backlight unit 200. Also, the more the light guide plate 230 has a thickness that gradually decreases, the more the light guide plate 230 is away from the light source unit 240.

In addition, one surface of the light guide plate 230 may have a specific pattern shape to supply uniform surface light. For example, the light guide plate 230 may have various patterns such as an elliptical pattern, polygonal pattern, hologram pattern, and the like to guide the incident light inward.

Although the light source unit 240 is disposed on a side surface of the light guide plate 230 in the drawing, it is not limited thereto. The light source unit 240 may be disposed to correspond to at least one surface of the light guide plate 230. For example, the light source unit 240 may be disposed to correspond to one side surface or both side surfaces of the light guide plate 230. Alternatively, the light source unit 240 may be disposed to correspond to a bottom surface of the light guide plate 230.

The reflection plate 220 may be disposed in a traveling path of light emitted from the light source unit 240. In more detail, the reflection plate 220 is disposed between the light guide plate 230 and the bottom case 210. That is, the reflection plate 220 is disposed under the light guide plate 230. The reflection plate 220 can reflect light traveling onto a top surface of the bottom case 210 toward the light guide plate 230 to improve light efficiency.

Unlike the drawing, if the light source unit 240 is disposed to correspond to the bottom surface of the light guide plate 230, the reflection plate 220 may be disposed on the light source unit 240. In more detail, the reflection plate 220 is disposed on the printed circuit board 240a of the light source unit 240. Also, the optical member 220 may have a plurality of holes to which the plurality of light sources 240 are coupled.

That is, the plurality of light sources 240b may be inserted into the plurality of holes of the reflection plate 220, and also, the light sources 240 may be exposed to the outside. Thus, the reflection plate 220 may be disposed on a side of the light source 240b on the printed circuit board 240a.

The optical sheet 260 is disposed on the light guide plate 230 to diffuse and collect light. For example, the optical sheet 260 may include a diffusion sheet 261, a first prism sheet 262, and a second prism sheet 263. The diffusion sheet 261 is disposed on the light guide plate 230. The diffusion sheet 261 may improve uniformity of light that is transmitted therethrough. The diffusion sheet 261 may include a plurality of beads.

The first prism sheet 262 is disposed on the diffusion sheet 261. The second prism sheet 263 is disposed on the first prism sheet 262. The first and second prism sheets 262 and 263 increase the linearity of light that is transmitted therethrough. Thus, the light emitted onto the light guide plate 230 passes through the optical sheet 260 and thus is changed into surface light having high brightness. In addition, the light conversion film 270 may be disposed between the optical sheet 260 and the light guide plate 230.

Next, the display panel 100 can form an image and be, for example, a liquid crystal display panel (LCD). For example, the display panel 100 includes a first substrate 110 and a second substrate 120 bonded to each other with a liquid crystal layer therebetween. Further, a polarizing plate for selectively transmitting only specifically polarized light may be further disposed on an outer surface of each of the first and second substrates 110 and 120. That is, a polarizing plate may be disposed on each of a top surface of the first substrate 110 and a bottom surface of the second substrate 120.

In addition, the display panel includes a display area and a non-display area. A gate line and data line are also disposed on one surface of the first substrate 110 on the display area. The gate line and the data line perpendicularly cross each other with a gate insulation layer therebetween to define a pixel area.

Further, the first substrate 110 may be a thin film transistor substrate. A thin film transistor may be disposed on an intersection area between the gate line and the data line on one surface of the first substrate 110. That is, the thin film transistor is disposed on the pixel area. Also, a pixel electrode is disposed on each of pixel areas on one surface of the first substrate 110. The thin film transistor and the pixel electrode are electrically connected to each other.

The thin film transistor includes a gate electrode, a semiconductor layer, a source electrode, and a drain electrode. The gate electrode is branched from the gate line. Also, the source electrode may be branched from the data line. The pixel electrode is electrically connected to the drain electrode of the thin film transistor. The thin film transistor includes a bottom gate structure, a top gate structure, or a double gate structure. That is, the thin film transistor may be changed and modified without departing from the spirit and scope of the embodiment.

The second substrate 120 may be a color filter substrate. A black matrix having a lattice shape that covers the non-display area such as the thin film transistor formed on the first substrate 110 and surrounds the pixel area may be disposed on one surface of the second substrate 120 of the display panel 100. Also, a red color filter layer, a green color filter layer, and a blue color filter layer that are successively repeatedly arranged to correspond to each of the pixel areas may be disposed in the lattice.

Also, the display panel 100 includes a common electrode that generates electrical fields with the pixel electrode so as to drive the liquid crystal layer. A method for arranging the liquid crystal molecules includes a twisted nematic (TN) mode, a vertical alignment (VA) mode, an in plane switching (IPS) mode, or fringe field switching (FFS) mode. The common electrode may be disposed on the first or second substrate 110 or 120 according to the arrangement method of the liquid crystal molecules.

Also, the display panel 100 may have a color filter on transistor (COT) structure in which the thin film transistor, the color filter layer, and the black matrix are formed on the first substrate 110. The second substrate 120 is also bonded to the first substrate 110 with the liquid crystal layer therebetween. That is, the thin film transistor may be disposed on the first substrate 110, and the color filter layer may be disposed on the thin film transistor. Here, a protection film may be disposed between the thin film transistor and the color filter layer.

Also, a pixel electrode contacting the thin film transistor is disposed on the first substrate 110. Here, the black matrix may be omitted to improve an aperture ratio and simplify a masking process. Thus, the common electrode may share the function of the black matrix.

In addition, a driving circuit part for supplying a driving signal is connected to the display panel 100. The driving circuit part may be mounted on the substrate of the display panel 100 or be connected to the display panel 100 through a connection member such as a tape carrier package.

Although the backlight unit and the display panel are described with reference to the drawings, the backlight unit and the display panel are not limited in constitution to those illustrated in the drawings. That is, a portion of the constitutions of the backlight unit and the display device may be omitted or modified. In addition, any component that is not described above may be added.

Next, the current embodiment will be described in detail with reference to an embodiment.

**Preparation Example 1: Quantum dot-polymer bead (I)**

Partially oxidized polyester having a number-average molecular weight of about 28,000 g/mol and a solubility parameter of about 22 Mpa$^{1/2}$ was dissolved into chloroform to prepare a polymer dispersion solution. The polymer dispersion solution contained about 25 wt% of polyester. A solvent of a ZnCdSe/ZnS quantum dot solution in which toluene solvent is dissolved substituted for chloroform to prepare a quantum dot dispersion solution (70 mg/mL). The quantum dot dispersion solution was added into the polymer dispersion solution, and then the mixture was stirred to form a quantum dot-polymer mixed solution. Here, the polymer dispersion solution and the quantum dot dispersion solution were mixed with each other so that the quantum dots within the quantum dot-polymer mixed solution had a content of about 0.5 wt%.

Polyvinyl alcohol was dissolved into water to form 1 wt% of a dispersing agent solution. Thereafter, about 10 g of the dispersing agent solution and about 2 g of quantum dot-polymer mixed solution were mixed with each other in a three neck flask. Then, the mixture was homogenized for one minute at about 10,000 rpm by using a homogenizer to form a liquid drop.

A magnetic stirring bar was inserted into the flask to stir the liquid drop by using the magnetic stirrer. When one side of the three neck flask is blocked, nitrogen was purged at the other side of the three neck flask, and simultaneously, vacuum was formed at further another side of the three neck flask by using a pump to volatilize the liquid drop for one hour.

After the solvent volatilization process is finished, the solution within the flask was filtered by using filtering equipment to collect a quantum dot-polymer bead on a filter. Then, the quantum dot-bead on the filter was cleaned several times by using ethanol and water. Thereafter, the quantum dot-bead was stored and dried for one day to remove remaining moisture and ethanol, thereby collecting a quantum dot-polymer bead (I). The above-described processes were performed at room temperature.

Next, Fig. 7 is a view illustrating the quantum dot-polymer bead (I) prepared through the above-described method. Referring to Fig. 7, it is seen that the quantum dot-polymer bead is formed.

**Preparation Example 2: Quantum dot-polymer bead (II)**

The same method as Preparation Example 1 except that an ethyl cellulose resin (Manufacturer: Sigma-Aldrich) having a solubility parameter of about 21.1 Mpa$^{1/2}$ instead of polyester is used, and a polymer dispersion solution and a quantum dot dispersion solution are mixed with each other so that a quantum dot within a quantum dot-polymer mixed solution has a content of about 1 wt% was performed to prepare a quantum dot-polymer bead (II).

**Preparation Example 3: Quantum dot-polymer bead (II)**

The same method as Preparation Example 2 except that a polymer dispersion solution and a quantum dot dispersion solution are mixed with each other so that a quantum dot within a quantum dot-polymer mixed solution has a content of about 3 wt% was performed to prepare a quantum dot-polymer bead (III).

**Preparation Example 4: Quantum dot-polymer bead (IV)**

The same method as Preparation Example 2 except that a polymer dispersion solution and a quantum dot dispersion solution are mixed with each other so that a quantum dot within a quantum dot-polymer mixed solution has a content of about 5 wt% was performed to prepare a quantum dot-polymer bead (IV).

**Preparation Example 5: Matrix resin**

Bisphenol A glycerolate diacrylate and trimethylolpropane triacrylate (TMPTA) were mixed with each other at a ratio of 4:1, and about 5 wt% of Irgacure 184 was added and stirred to form an epoxy acrylate resin.

**Preparation Example 6: Mixed resin A for light conversion composite**

About 3 wt% of the quantum dot-polymer bead (I) obtained by Preparation Example 1 was added to about 97 wt% of epoxy acrylate resin prepared by Preparation Example 5 and then stirred to prepare a mixed resin A for a light conversion composite.

**Preparation Example 7: Mixed resin B for light conversion composite**

The same method as Preparation Example 6 except that the quantum dot-polymer bead (II) obtained by Preparation Example 2 instead of the quantum dot-polymer bead (I) is used was performed to prepare a mixed resin B for a light conversion composite.

**Preparation Example 8: Mixed resin C for light conversion composite**

The same method as Preparation Example 6 except that the quantum dot-polymer bead (III) obtained by Preparation Example 3 instead of the quantum dot-polymer bead (I) is used was performed to prepare a mixed resin C for a light conversion composite.

**Preparation Example 9: Mixed resin D for light conversion composite**

The same method as Preparation Example 6 except that the quantum dot-polymer bead (IV) obtained by Preparation Example 4 instead of the quantum dot-polymer bead (I) is used was performed to prepare a mixed resin D for a light conversion composite.

Embodiment 1

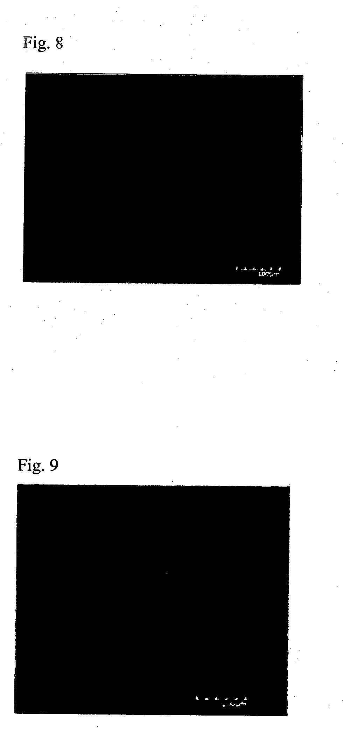

The mixed resin A for the light conversion composite prepared by Preparation Example 6 was applied between a first barrier film (i-component, 50 $\mu$m) and a second barrier film (i-component, 50 $\mu$m) and then exposed to ultraviolet rays (UV) to prepare a light conversion film. Fig. 8 is an optical microscope photograph of the light conversion film prepared by Embodiment 1. Referring to Fig. 8, it is seen that the quantum dot-polymer beads are dispersed within the film.

Embodiment 2

The same method as Embodiment 1 except for the mixed resin B for the light conversion composite prepared by Preparation Example 7 instead of the mixed resin A for the light conversion composite is used was performed to prepare a light conversion film.

Embodiment 3

The same method as Embodiment 1 except for the mixed resin C for the light conversion composite prepared by Preparation Example 8 instead of the mixed resin A for the light conversion composite is used was performed to prepare a light conversion film.

Embodiment 4

The same method as Embodiment 1 except for the mixed resin D for the light conversion composite prepared by Preparation Example 9 instead of the mixed resin A for the light conversion composite is used was performed to prepare a light conversion film.

Comparison Example

ZnCdSe/ZnS quantum dots were dissolved into a lauryl acrylate monomer to form a quantum dot-monomer solution. Trimethylolpropane triacrylate (TMPTA) and Irgacure 184 were mixed with each other and then stirred to form an acrylic resin. Then, the quantum dot-monomer solution was added to the acrylic resin and then stirred to apply the mixture between a first barrier film (i-component, 50 $\mu$m) and a second barrier film (i-component, 50 $\mu$m). Then, the result was exposed to UV and then cured to prepare a light conversion film.

Fig. 9 is an optical microscope photograph of the light conversion film prepared by Comparison Example. Referring to Fig. 9, it is seen that the optical film prepared by the Comparison Example is distributed over the light conversion layer, but the quantum dots do not form the bead.

Experimental Example 1: Small angle X-ray scattering measurement

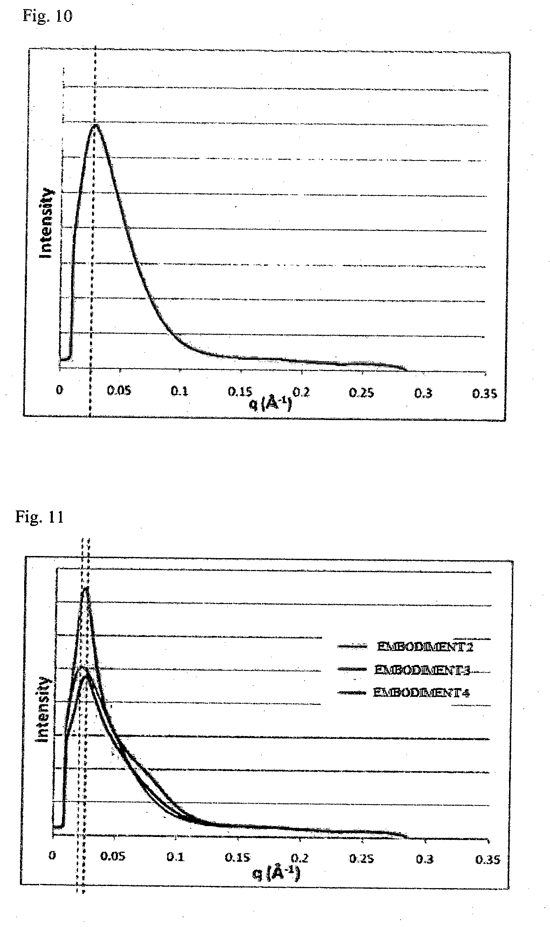

Scattering intensities according to wave numbers q of the light conversion films prepared by Embodiment 1 to 4 were measured by using a transmission small angle X-ray scattering beam of the Pohang light source (PLS). Fig. 10 is a graph showing results obtained in Embodiment 1, and Fig. 11 is a graph results obtained in Embodiments 2 to 4. The wave number q at a peak point of the scattering intensity obtained through the graphs and a quantum dot distance d calculated by using the wave number q are as follows in Table 1.

[Table 1]

| Classification | Wave number q($Å^{-1}$) | Distance d(nm) |
|---|---|---|
| Embodiment 1 | 0.02592 | 24.2 |
| Embodiment 2 | 0.021793 | 28.8 |
| Embodiment 3 | 0.024545 | 25.5 |
| Embodiment 4 | 0.023398 | 26.8 |

Referring to Table 1 and Figs. 10 and 11, it is seen that, the light conversion films prepared by Embodiments 1 to 4 are measured by the small angle X-ray scattering method, the wave number q at the peak point satisfies the appended Claims, i.e., 0.0056 $Å^{-1}$ to 0.045 $Å^{-1}$. Also, referring to Fig. 11 and the results measured in Embodiments 2 to 4 as shown in Table 1, it is seen that the quantum dots are distributed with a relatively uniform distance regardless of the content of the quantum dot-polymer bead. This represent that the quantum dot-polymer beads are constituted by quantum dot-polymer units.

**Experimental Example 2: Light emitting efficiency measurement**

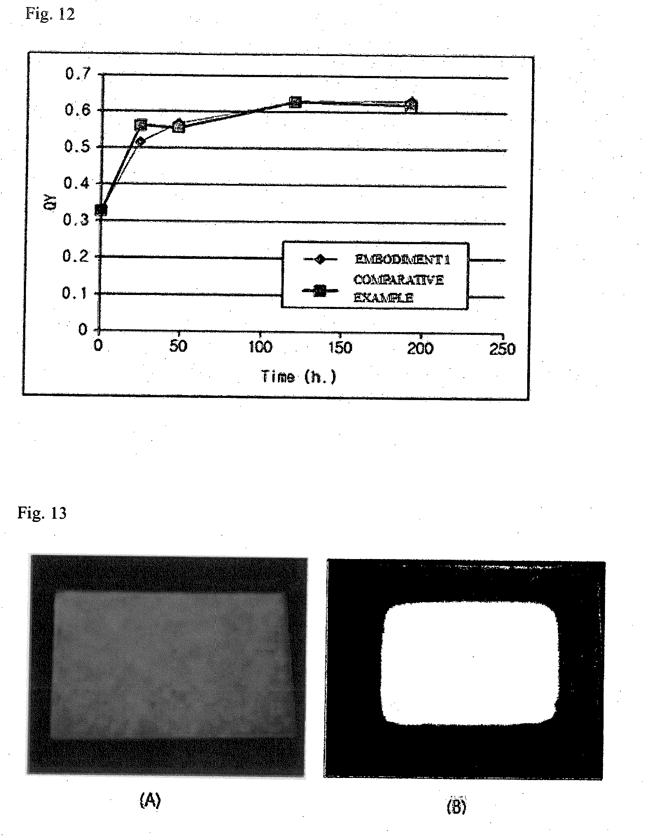

Light emitting efficiency QY of the light conversion film prepared by Embodiment 1 and the light conversion film prepared by Comparison Example was measured. The measured results were illustrated in Fig. 12. Referring to Fig. 12, it is seen that the light conversion film including the bead-shaped quantum dot according to an embodiment and the light conversion film in which the quantum dots are uniformly distributed over the entire surface according to Comparison Example have light emitting efficiency QY that are almost similar to each other.

**Experimental Example 3: Edge degradation measurement**

A test for measuring a degree of degradation at the edges of the light conversion films prepared by Embodiment 1 and Comparison Example after leaving about ten days under the conditions of a temperature of about 60°C and relative humidity of about 90% was conducted. In particular, Fig. 13A is a photograph of the light conversion film about 10 days later after being prepared by Embodiment 1, and Fig. 13B is a photograph of the light conversion film about 10 days later after being prepared by Comparison Example. As illustrated in Fig. 13, it is seen that the edge degradation does not occur at all in the light conversion film of Embodiment 1, but the damaged length of about 6 mm or more due to the degradation at the edge portion occurs in the light conversion film of Comparison Example.

In the light conversion composite prepared by using the preparing method according to the embodiment, because quantum dots within the quantum dot-polymer bead are spaced apart from each other, the reduction in light emitting efficiency due to the aggregation of the quantum dots is minimized.

Also, in the light conversion composite according to an embodiment of the present invention, because the resin having the low vapor-permeation rate and moisture-permeation rate is used as the matrix resin, the degradation at the edge portion is minimized when the light conversion film is prepared by using the light conversion composite

Also, because the light conversion composite according to an embodiment of the present invention is prepared at room temperature, the quantum dot degradation that occurs at the high-temperature process may be prevented.

Although embodiments have been described with reference to a number of illustrative embodiments thereof, it should be understood that numerous other modifications and embodiments can be devised by those skilled in the art that will fall within the scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

**Claims**

1. A light conversion film (270) comprising:

   a first barrier film (271);
   a light conversion layer (272) disposed on the first barrier film (271), the light conversion layer (272) including a light conversion composite comprising a matrix resin (400) and quantum dot-polymer beads (300) dispersed within the matrix resin (400); and
   a second barrier film (273) disposed on the light conversion layer (272), wherein
   each of the quantum dot-polymer beads (300) has the form of a cluster and is formed by aggregating a plurality of quantum dot-polymer units (310),
   each of the quantum dot-polymer units (310) includes a quantum dot (311) and a polymer (312) surrounding the quantum dot surface and of which a portion of a chain is bonded to a surface of the quantum dot (311) to form a coating layer, and
   the quantum dot distance is 14 nm to 112 nm.

2. The light conversion film (270) according to claim 1, wherein each of the quantum dot-polymer beads (300) has a mean diameter of 5 $\mu$m to 200 $\mu$m.

3. The light conversion film (270) according to claim 1 or 2, wherein each of quantum dots (311) within the quantum dot-polymer beads (300) has a concentration of 0.1wt% to 1wt%.

4. The light conversion film (270) according to any of claims 1 to 3, wherein the polymer (312) comprises at least one selected from the group consisting of polyester, ethyl cellulose, and polyvinylpyridine on the main chain.

5. The light conversion film (270) according to any of claims 1 to 4, wherein the polymer (312) comprises partially oxidized polyester.

6. The light conversion film (270) according to any one preceding claim, further comprising a dispersing agent (320) attached to a surface of each of the quantum dot-polymer beads (300).

7. The light conversion film (270) according to any one preceding claim, wherein the quantum dot-polymer beads (300) includes pores.

8. The light conversion film (270) according to any one preceding claim, wherein the light conversion composite comprises at least one selected from the group consisting of a red light emitting quantum dot that converts incident light into red light and a green light emitting quantum dot that converts incident light into green light.

9. The light conversion film (270) according to any one preceding claim, wherein the matrix resin (400) comprises at least one selected from the group consisting of epoxy, epoxy acrylate, polychloro tri-fluoroethylene, polyethylene, polypropylene, and polyvinyl alcohol.

10. The light conversion film (270) according to any one preceding claim, wherein the light conversion film (270) has a damaged length of 2 mm or less at an edge portion that is measured after leaving about ten days under conditions of a temperature of 60°C and relative humidity of 90%.

11. A backlight unit (200) comprising:

   a light source unit (240) comprising a plurality of light sources (240b); and
   a light conversion film (270) according to any one of claims 1 to 10.

12. A display device comprising:

   a backlight unit (200) comprising a light source unit (240) comprising a plurality of light sources (240b) and a light conversion film (270) according to any one of claims 1 to 10; and
   a display panel (100) disposed on the backlight unit (200).

**Patentansprüche**

1. Lichtumwandlungsfilm (270) umfassend:

   einen ersten Barrierefilm (271);
   eine Lichtumwandlungsschicht (272), die auf dem ersten Barrierefilm (271) angeordnet ist, wobei die Lichtumwandlungsschicht (272) ein Lichtumwandlungskomposit enthält, welches ein Matrixharz (400) und in dem Matrixharz (400) dispergierte Quantenpunkt-Polymerkugeln (300) umfasst; und
   einen zweiten Barrierefilm (273), der auf der Lichtumwandlungsschicht (272) angeordnet ist, wobei jede der Quantenpunkt-Polymerkugeln (300) die Form eines Clusters aufweist und durch Aggregieren einer Mehrzahl von Quantenpunkt-Polymereinheiten (310) gebildet ist,
   wobei jede der Quantenpunkt-Polymereinheiten (310) einen Quantenpunkt (311) und ein Polymer (312), welches die Quantenpunktoberfläche umgibt und von welchem ein Abschnitt einer Kette mit einer Oberfläche des Quantenpunkts (311) verbunden ist, um eine Deckschicht zu bilden, enthält,
   und wobei die Quantenpunkt-Distanz 14 nm bis 112 nm beträgt.

2. Lichtumwandlungsfilm (270) nach Anspruch 1, wobei jede der Quantenpunkt-Polymerkugeln (300) einen mittleren Durchmesser von 5 $\mu$m bis 200 $\mu$m aufweist.

3. Lichtumwandlungsfilm (270) nach Anspruch 1 oder 2, wobei jeder der Quantenpunkte (311) innerhalb der Quantenpunkt-Polymerkugeln (300) eine Konzentration von 0,1 Gew.-% bis 1 Gew.% aufweist.

4. Lichtumwandlungsfilm (270) nach einem beliebigen der Ansprüche 1 bis 3, wobei das Polymer (312) mindestens eines ausgewählt aus der Gruppe bestehend aus Polyester, Ethylcellulose und Polyvinylpyridin auf der Hauptkette umfasst.

5. Lichtumwandlungsfilm (270) nach einem beliebigen der Ansprüche 1 bis 4, wobei das Polymer (312) teilweise oxidierten Polyester umfasst.

6. Lichtumwandlungsfilm (270) nach einem beliebigen der vorhergehenden Ansprüche, des weiteren umfassend ein Dispergiermittel (320), welches an eine Oberfläche von jeder der Quantenpunkt-Polymerkugeln (300) angebracht ist.

7. Lichtumwandlungsfilm (270) nach einem beliebigen vorhergehenden Anspruch, wobei die Quantenpunkt-Polymerkugeln (300) Poren enthalten.

8. Lichtumwandlungsfilm (270) nach einem beliebigen vorhergehenden Anspruch, wobei das Lichtumwandlungskomposit mindestens eines ausgewählt aus der Gruppe bestehend aus einem rotes Licht-emittierenden Quantenpunkt, der einfallendes Licht in rotes Licht umwandelt, und einem grünes Licht-emittierenden Quantenpunkt, der einfallendes Licht in grünes Licht umwandelt, umfasst.

9. Lichtumwandlungsfilm (270) nach einem beliebigen der vorhergehenden Ansprüche, wobei das Matrixharz (400) mindestens eines ausgewählt aus der Gruppe bestehend aus Epoxy, Epoxyacrylat, Polychlortrifluorethylen, Polyethylen, Polypropylen und Polyvinylalkohol umfasst.

10. Lichtumwandlungsfilm (270) nach einem beliebigen der vorhergehenden Ansprüche, wobei der Lichtumwandlungsfilm (270) eine beschädigte Länge von 2 mm oder weniger an einem Randabschnitt aufweist, die nach zehn Tagen unter Bedingungen einer Temperatur von 60 °C und relativer Luftfeuchtigkeit von 90% gemessen ist.

11. Rückbeleuchtungseinheit (200), umfassend:

   eine Lichtquelleneinheit (240) umfassend eine Mehrzahl von Lichtquellen (240b); und
   einen Lichtumwandlungsfilm (270) nach einem beliebigen der Ansprüche 1 bis 10.

12. Anzeigevorrichtung umfassend:

   eine Rückbeleuchtungseinheit (200) umfassend eine Lichtquelleneinheit (240) umfassend eine Mehrzahl von Lichtquellen (240b) und einen Lichtumwandlungsfilm (270) nach einem beliebigen der Ansprüche 1 bis 10; und
   ein Anzeigepanel (100), welches auf der Rückbeleuchtungseinheit (200) angeordnet ist.

**Revendications**

1. Film de conversion de lumière (270) comprenant :

   un premier film barrière (271) ;
   une couche de conversion de lumière (272) disposée sur le premier film barrière (271), la couche de conversion de lumière (272) comportant un composite de conversion de lumière comprenant une résine matrice (400) et des billes de polymère à points quantiques (300) dispersées dans la résine matrice (400) ; et
   un second film barrière (273) disposé sur la couche de conversion de lumière (272), dans lequel
   chacune des billes de polymère à points quantiques (300) a la forme d'un amas et est formée par agrégation d'une pluralité d'unités de polymère à points quantiques (310),
   chacune des unités de polymère à points quantiques (310) comprend un point quantique (311) et un polymère (312) entourant la surface du point quantique et dont une partie d'une chaîne est liée à une surface du point quantique (311) pour former une couche de revêtement, et
   la distance des points quantiques est comprise entre 14 nm et 112 nm.

2. Film de conversion de lumière (270) selon la revendication 1, dans lequel chacune des billes de polymère à points quantiques (300) a un diamètre moyen de 5 $\mu$m à 200 $\mu$m.

3. Film de conversion de lumière (270) selon la revendication 1 ou 2, dans lequel chacun des points quantiques (311) dans les billes de polymère à points quantiques (300) a une concentration de 0,1 % en poids à 1 % en poids.

4. Film de conversion de lumière (270) selon l'une quelconque des revendications 1 à 3, dans lequel le polymère (312) comprend au moins un polymère choisi dans le groupe constitué par le polyester, l'éthylcellulose et la polyvinylpyridine sur la chaîne principale.

5. Film de conversion de lumière (270) selon l'une quelconque des revendications 1 à 4, dans lequel le polymère (312) comprend un polyester partiellement oxydé.

6. Film de conversion de lumière (270) selon l'une quelconque des revendications précédentes, comprenant en outre un agent dispersant (320) fixé à une surface de chacune des billes de polymère à points quantiques (300).

7. Film de conversion de lumière (270) selon l'une quelconque des revendications précédentes, dans lequel les billes de polymère à points quantiques (300) comprennent des pores.

8. Film de conversion de lumière (270) selon l'une quelconque des revendications précédentes, dans lequel le composite de conversion de lumière comprend au moins un élément choisi dans le groupe constitué par un point quantique émettant de la lumière rouge qui convertit la lumière incidente en lumière rouge et un point quantique émettant de la lumière verte qui convertit la lumière incidente en lumière verte.

9. Film de conversion de lumière (270) selon l'une quelconque des revendications précédentes, dans lequel la résine matrice (400) comprend au moins un élément choisi dans le groupe constitué par l'époxy, l'acrylate d'époxy, le polychloro tri-fluoroéthylène, le polyéthylène, le polypropylène et l'alcool polyvinylique.

10. Film de conversion de lumière (270) selon l'une quelconque des revendications précédentes, dans lequel le film de conversion de lumière (270) a une longueur endommagée de 2 mm ou moins au niveau d'une partie de bord qui est mesurée après séjour environ dix jours dans des conditions d'une température de 60 °C et d'une humidité relative de 90 %.

11. Unité de rétroéclairage (200) comprenant :

une unité de source de lumière (240) comprenant une pluralité de sources de lumière (240b) ; et
un film de conversion de lumière (270) selon l'une quelconque des revendications 1 à 10.

12. Dispositif d'affichage comprenant :

une unité de rétroéclairage (200) comprenant une unité de source de lumière (240) comprenant une pluralité de sources de lumière (240b) et un film de conversion de lumière (270) selon l'une quelconque des revendications 1 à 10 ; et
un panneau d'affichage (100) disposé sur l'unité de rétroéclairage (200).

Fig. 1

Fig. 2

300    400

Fig. 3

300

Fig. 4

Fig. 5

Fig. 6

Fig. 7

100 μm

Fig. 8

Fig. 9

Fig. 10

Fig. 11

Fig. 12

Fig. 13

(A)                                                        (B)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2660885 A1

- US 2011227034 A1

**Non-patent literature cited in the description**

- Polymer handbook. John Wiley & Sons, 1999